# EUROPEAN PATENT APPLICATION

(11) **EP 2 509 104 A2**
(43) Date of publication of application: **10.10.2012**
(21) Application number: 11007222.0
(22) Date of filing: 06.09.2011
(51) Int. Cl.: H01L 23/373

(54) **Ceramic heat sink module and manufacturing method thereof**

(30) Priority: 08.04.2011 TW 100112237
(71) Applicant: Yuen Jinn Electrical Ceramic Co., Ltd., Shulin Dist T'ai pei 23841 (TW)
(72) Inventor: Hsueh, Chin-Lung, 23841 New Taipei City (TW)
(74) Representative: Altenburg, Bernardus Stephanus Franciscus

(57) **Abstract**

A ceramic heat sink module for lowering a temperature of a heating element is disclosed. The ceramic heat sink module includes a ceramic heat sink module body, wherein a composition of the ceramic heat sink module body includes at least 70% by weight aluminium oxide.

## Description

### BACKGROUND OF THE INVENTION

### Field of the Invention

The present invention relates to a ceramic heat sink module and a manufacturing method thereof; more particularly, the present invention relates to a ceramic heat sink module with aluminium oxide as its principle component, and a manufacturing method thereof.

### Description of the Related Art

An electronic device is usually equipped with various types of circuit boards, and the circuit boards comprise various types of heating elements (such as a central processing unit, a graphics processor, or other chips). During operation, the heating element would generate huge amount of heat and cause a temperature of the heating element to increase. If the heat cannot be effectively and immediately dissipated, the operation of each electronic element or the entire electronic device would be affected. When things get worse, the heating element might be damaged due to overheat. In order to keep the heating element operating normally under an appropriate temperature, the heating element is usually installed with a heat sink module, so as to transfer the heat generated by the heating element to the heat sink module, thereby achieving the object of lowering the temperature of the heating element.

Each electronic element installed in the electronic device is usually integrated with various types of high-frequency circuits, digital circuits and analog circuits, wherein electromagnetic interference (EMI) would be mutually generated while they are operating, and the function of the electronic element would be affected accordingly. In order to avoid the electromagnetic interference, the electromagnetic interference shielding needs to be taken into consideration while arranging the electronic element.

With regard to conventional heat sink modules, aluminium or aluminium alloy are commonly used as the material for the heat sink modules. The aluminium or aluminium alloy heat sink module has high thermal conductivity (such as 168 W/mK). However, the aluminium or aluminium alloy heat sink module also has high capacity (such as around 0.897 J/K), which would retain heat energy in the heat sink module to reduce heat dissipation effect. Further, while using the aluminium or aluminium alloy heat sink module, a metal sheet (such as an iron sheet) needs to be added between the aluminium or aluminium alloy heat sink module and the heating element, so as to avoid the electromagnetic interference. However, such design would increase the assembly time as well as increase the thickness and weight of the heat sink module. Moreover, due to continuous increase of metal prices, the cost of the aluminium or aluminium alloy heat sink module are continuously risen, which causes the increase of the manufacturing cost.

With regard to conventional heat sink modules, silicon carbide (or porous silicon carbide) can also be used as the material for the heat sink modules. Although the silicon carbide heat sink module can avoid the electromagnetic interference, it has poorer heat dissipation effect with its thermal conductivity of only 6.79 W/mK.

Therefore, there is a need to provide a ceramic heat sink module and a manufacturing method thereof to mitigate and/or obviate the aforementioned problems.

### SUMMARY OF THE INVENTION

It is an object of the present invention to provide a ceramic heat sink module capable of both avoiding electromagnetic interference and providing heat dissipation effect, and a manufacturing method thereof

To achieve the abovementioned object, the ceramic heat sink module of the present invention is used for lowering a temperature of a heating element. The ceramic heat sink module comprises a ceramic heat sink module body, wherein a composition of the ceramic heat sink module body substantially includes at least 70% by weight aluminium oxide.

In one embodiment of the present invention, the composition of the ceramic heat sink module body substantially includes at least 80% by weight aluminium oxide.

In one embodiment of the present invention, the composition of the ceramic heat sink module body further includes 10% to 20% by weight silicon dioxide.

To achieve the abovementioned object, the manufacturing method of a ceramic heat sink module of the present invention is used for lowering a temperature of a heating element installed in a display device. The manufacturing method of the ceramic heat sink module comprises the following steps: mixing aluminium oxide powder to form a slurry; injecting the slurry into a mold and performing a first formation manufacturing process to make the slurry form a greenware; taking out the greenware; and performing a sintering manufacturing process to the greenware to form a ceramic heat sink module.

In one embodiment of the present invention, the step of mixing the aluminium oxide powder to form the slurry further comprises: mixing the aluminium oxide powder and silicon dioxide powder to form the slurry.

To achieve the abovementioned object, the manufacturing method of a ceramic heat sink module of the present invention is used for lowering a temperature of a heating element installed in a display device. The manufacturing method of the ceramic heat sink module comprises the following steps: mixing aluminium oxide powder to form a slurry; removing excess water from the slurry to form a porcelain clay, and making the porcelain clay pass through a mold to form a fin-shaped greenware; and performing a sintering manufacturing process to the greenware to form a ceramic heat sink module.

In one embodiment of the present invention, after the step of removing excess water from the slurry to form the porcelain clay and making the porcelain clay pass through the mold to form the fin-shaped greenware, the manufacturing method further comprises: cutting the green ware; and naturally drying the greenware.

Other objects, advantages, and novel features of the invention will become more apparent from the following detailed description when taken in conjunction with the accompanying drawings.

### BRIEF DESCRIPTION OF THE DRAWINGS

These and other objects and advantages of the present invention will become apparent from the following description of the accompanying drawings, which disclose several embodiments of the present invention. It is to be understood that the drawings are to be used for purposes of illustration only, and not as a definition of the invention.

In the drawings, wherein similar reference numerals denote similar elements throughout the several views:
FIG. 1 illustrates a structural schematic drawing of a ceramic heat sink module according to one embodiment of the present invention.
FIG. 2 is a component analysis table of the ceramic heat sink module according to one embodiment of the present invention.
FIG. 3 is a physical property analysis table of the ceramic heat sink module according to one embodiment of the present invention.
FIG. 4 illustrates a schematic drawing showing the ceramic heat sink module installed in a display device according to one embodiment of the present invention.
FIG. 5 illustrates a flowchart of a manufacturing method of the ceramic heat sink module according to one embodiment of the present invention.
FIG. 6 illustrates a flowchart of a manufacturing method of the ceramic heat sink module according to another embodiment of the present invention.

### DETAILED DESCRIPTION OF THE PREFERRED EMBODIMENT

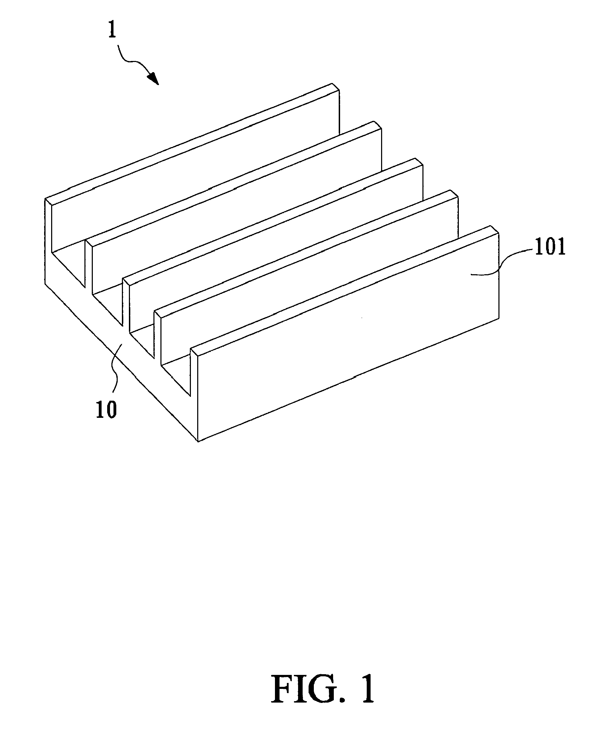

As shown in FIG. 1, a ceramic heat sink module 1 of the present invention comprises a ceramic heat sink module body 10. The ceramic heat sink module body 10 comprises a plurality of heat sink fins 101, wherein the heat sink fins 101 are used for enhancing heat dissipation effect. Please note that the shape of the ceramic heat sink module 1 is not limited to what illustrated in FIG. 1. The ceramic heat sink module 1 of the present invention can be in different shapes (such as in a round shape or in a rectangular shape) according to the size of a heating element. The number and shape of the heat sink fins 101 can also be varied.

In one embodiment of the present invention, a composition of the ceramic heat sink module body 10 substantially includes at least 80% by weight aluminium oxide (Al₂O₃), 10% to 20% by weight silicon dioxide (SiO₂), and other additives.

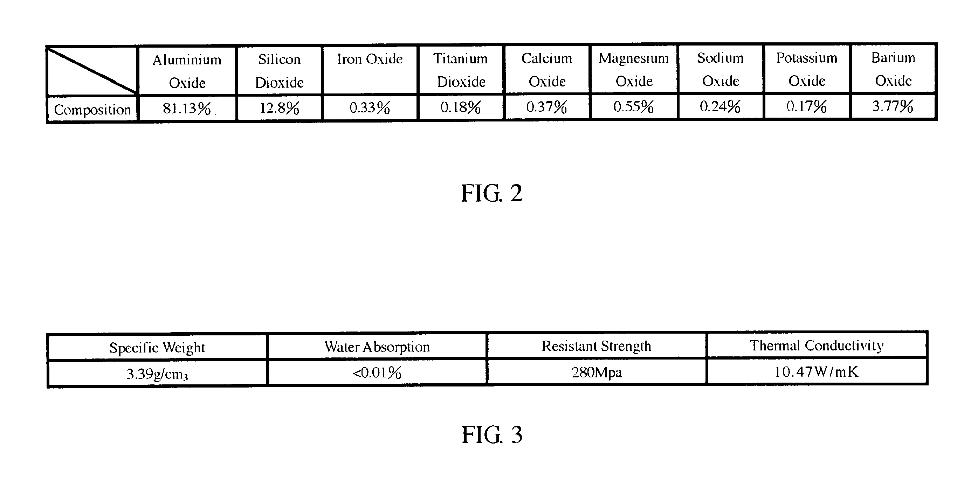

Please refer to FIG. 2, which is a component analysis table showing the composition of the ceramic heat sink module body 10 after performing experimental analysis to the ceramic heat sink module 1 according to one embodiment of the present invention. As shown in FIG. 2, the composition of the ceramic heat sink module body 10 includes, but not limited to, 81.13% by weight aluminium oxide, 12.8% by weight silicon dioxide, 0.33% by weight iron oxide (Fe₂O₃), 0.18% by weight titanium dioxide (TiO₂), 0.37% by weight calcium oxide, 0.55% by weight magnesium oxide (MgO), 0.24% by weight sodium oxide (Na₂O), 0.17% by weight potassium oxide (K₂O) and 3.77% by weight barium oxide (BaO) . Please refer to FIG. 3, which is a physical property analysis table of the ceramic heat sink module 1 according to one embodiment of the present invention. As shown in FIG. 3, the ceramic heat sink module body 10 has its specific weight of 3.39 g/cm³, water absorption less than 0.01%, resistant strength of 280 Mpa, and thermal conductivity of 10.47 W/mK.

Please note that in another embodiment of the present invention, the composition of the ceramic heat sink module body 10 can also include at least 70% by weight aluminium oxide (with the rest composed of silicon dioxide and other additives) or nearly pure aluminium oxide (with partial additives).

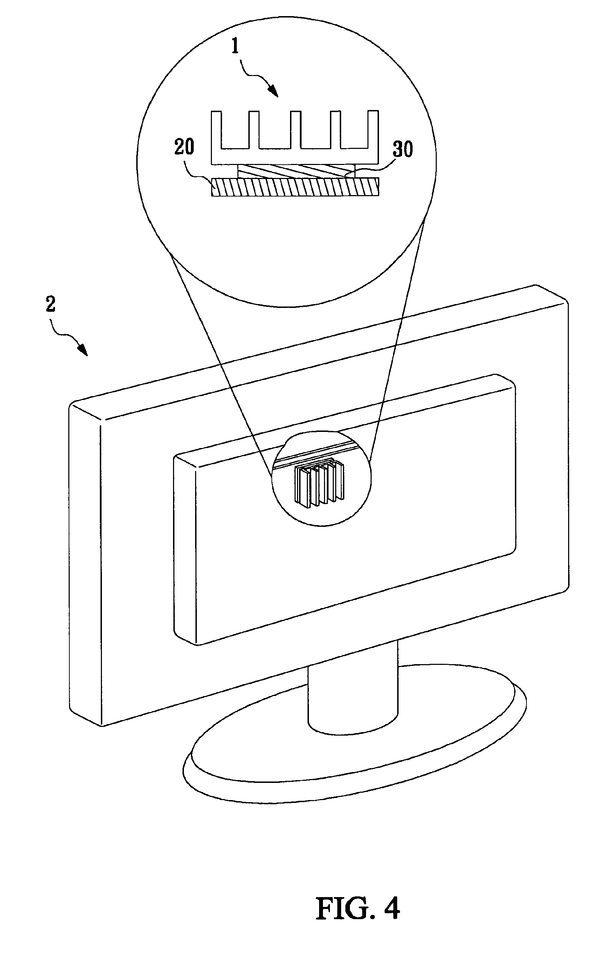

As shown in FIG. 4, which illustrates a schematic drawing showing the ceramic heat sink module 1 installed in a display device according to one embodiment of the present invention. As shown in FIG. 4, the ceramic heat sink module 1 of the present invention is used for lowering a temperature of a heating element 20. In one embodiment of the present invention, the heating element 20 is, but not limited to, a driver circuit chip installed in a signal circuit board of a display device 2. A thermal tape 30 is attached between the ceramic heat sink module 1 and the heating element 20, such that the ceramic heat sink module 1 can be attached onto the heating element 20. In one embodiment of the present invention, the display device 2 is, but not limited to, a liquid crystal display television. For example, the display device 2 can also be a plasma television or a desktop liquid crystal display.

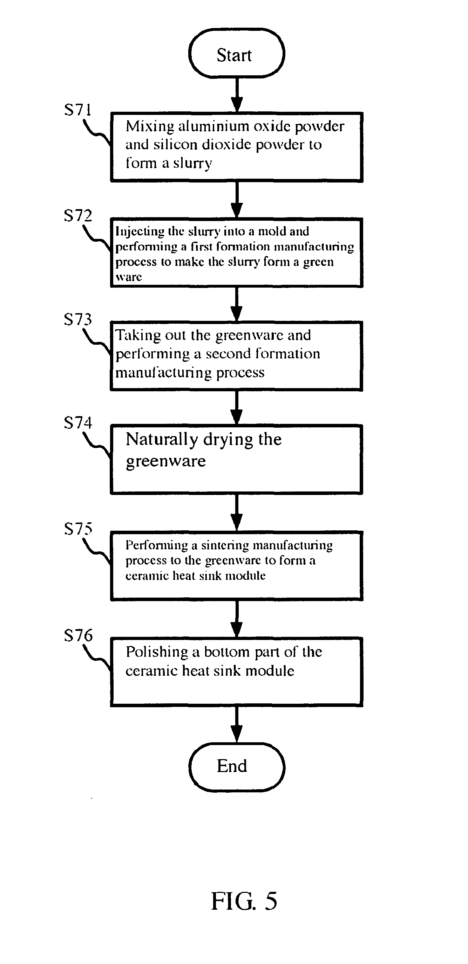

Next, please refer to FIG. 5, which illustrates a flowchart of a manufacturing method of the ceramic heat sink module 1 according to one embodiment of the present invention.

As shown in FIG. 5, the present invention firstly performs step S71: mixing aluminium oxide powder and silicon dioxide powder to form a slurry.

In step S71, the aluminium oxide powder, silicon dioxide powder and adhesive are mixed evenly to form the slurry.

Then, the present invention performs step S72: injecting the slurry into a mold and performing a first formation manufacturing process to make the slurry form a greenware.

In step S72, the slurry is injected into the mold by way of high-pressure extrusion molding, and the first formation manufacturing process makes the slurry form the greenware by means of dry pressing, isostatic pressing or hot pressure casting.

Then, the present invention performs step S73: taking out the greenware and performing a second formation manufacturing process.

In step S73, the greenware is taken out from the mold, and the second formation manufacturing process comprises: forming a plurality of sheet structures (i.e. the pre-formation of the heat sink fins) on the greenware, or cutting the greenware into an appropriate size corresponding to the heating element. Please note that the second formation manufacturing process is not an essential step in the present invention, and the second formation manufacturing process is not limited to forming a plurality of sheet structures on the greenware.

Then, the present invention performs step S74: naturally drying the green ware.

Next, the present invention performs step S75: performing a sintering manufacturing process to the greenware to form the ceramic heat sink module 1.

In step S75, the sintering manufacturing process is performed to the greenware to achieve greenware densification, so as to form the ceramic heat sink module 1 as shown in FIG. 1.

Finally, the present invention performs step S76: polishing a bottom part of the ceramic heat sink module 1.

In step S76, the bottom part of the ceramic heat sink module 1 is polished to facilitate the adhesion of the thermal tape afterwards.

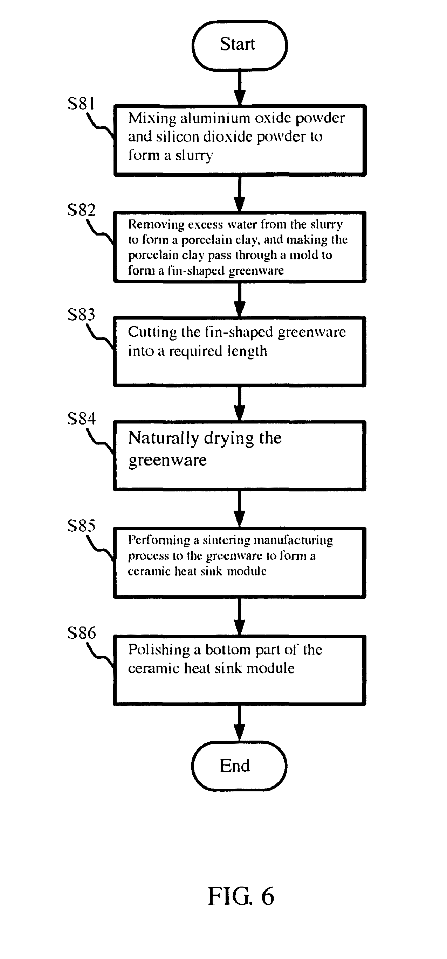

Then, please refer to FIG. 6, which illustrates a flowchart of a manufacturing method of the ceramic heat sink module 1 according to another embodiment of the present invention.

As shown in FIG. 6, the present invention firstly performs step S81: mixing aluminium oxide powder and silicon dioxide powder to form a slurry.

In step S81, the aluminium oxide powder, silicon dioxide powder and adhesive are mixed evenly to form the slurry.

Then, the present invention performs step S82: removing excess water from the slurry to form a porcelain clay, and making the porcelain clay pass through a mold to form a fin-shaped greenware.

In step S82, after excess water is removed from the slurry to form the porcelain clay, the porcelain clay would be extruded from the mold to form the fin-shaped greenware.

Then, the present invention performs step S83: cutting the fin-shaped greenware into a required length.

In another embodiment of the present invention, the fin-shaped greenware can be cut into a practically-used size.

Then, the present invention performs step S84: naturally drying the greenware.

Next, the present invention performs step S85: performing a sintering manufacturing process to the greenware to form the ceramic heat sink module 1.

In step S85, the sintering manufacturing process is performed to the green ware to achieve greenware densification, so as to form the ceramic heat sink module 1 as shown in FIG. 1.

Finally, the present invention performs step S86: polishing a bottom part of the ceramic heat sink module 1.

In step S86, the bottom part of the ceramic heat sink module 1 is polished to facilitate the adhesion of the thermal tape afterwards.

Please note that although the thermal conductivity of the ceramic heat sink module 1 of the present invention is not as high as that of the aluminium or aluminium alloy heat sink module, the ceramic heat sink module 1 of the present invention can still be applied in a heating element with a lower heating power, such as a chip of a display device or a chip of an industrial computer. The abovementioned heating element does not need a heat sink module with excellent heat dissipation effect, therefore the ceramic heat sink module 1 of the present invention is capable of satisfying the heat dissipation requirement of the abovementioned heating element with the lower heating power.

As a result, the ceramic heat sink module 1 of the present invention at least includes the following advantages: (1) avoiding electromagnetic interference generated among the heating element and other electronic components without the need of installing an extra metal sheet, so as to reduce the thickness and assembly cost of the ceramic heat sink module; (2) reducing the manufacturing cost by utilizing aluminium oxide which has a lower cost and an easier manufacturing process; (3) providing better heat dissipation effect than the silicon carbide heat sink module does.

Although the present invention has been explained in relation to its preferred embodiments, it is to be understood that many other possible modifications and variations can be made without departing from the spirit and scope of the invention as hereinafter claimed.

## Claims

1. A ceramic heat sink module comprising:
a ceramic heat sink module body, wherein a composition of the ceramic heat sink module body substantially includes at least 70% by weight aluminium oxide.

2. The ceramic heat sink module as claimed in claim 1, wherein the composition of the ceramic heat sink module body substantially includes at least 80% by weight aluminium oxide.

3. The ceramic heat sink module as claimed in claim 1 or 2, wherein the composition of the ceramic heat sink module body further includes 10% to 20% by weight silicon dioxide.

4. The ceramic heat sink module as claimed in claim 3, wherein the ceramic heat sink module body further includes a plurality of heat sink fins.

5. A manufacturing method of a ceramic heat sink module, used for lowering a temperature of a heating element installed in a display device, the manufacturing method comprising the following steps:
mixing aluminium oxide powder to form a slurry;
injecting the slurry into a mold and performing a first formation manufacturing process to make the slurry form a green ware;
taking out the green ware; and
performing a sintering manufacturing process to the green ware to form a ceramic heat sink module.

6. The manufacturing method as claimed in claim 5, wherein the step of mixing the aluminium oxide powder to form the slurry further comprises: mixing the aluminium oxide powder and silicon dioxide powder to form the slurry.

7. The manufacturing method as claimed in claim 5 or 6, wherein the step of taking out the green ware further comprises: taking out the green ware and performing a second formation manufacturing process, where the second formation manufacturing process includes forming a plurality of sheet structures on the green ware.

8. The manufacturing method as claimed in claim 7, wherein after the step of taking out the green ware and performing the second formation manufacturing process, the manufacturing method further comprises: naturally drying the green ware.

9. The manufacturing method as claimed in claim 8, wherein after the step of performing the sintering manufacturing process to the green ware to form the ceramic heat sink module, the manufacturing method further comprises: polishing a bottom part of the ceramic heat sink module.

10. The manufacturing method as claimed in claim 6, 8 or 9, wherein a composition of the ceramic heat sink module substantially includes 80% to 100% by weight aluminium oxide and 10% to 20% by weight silicon dioxide.

11. A manufacturing method of a ceramic heat sink module, used for lowering a temperature of a heating element installed in a display device, the manufacturing method comprising the following steps:
mixing aluminium oxide powder to form a slurry;
removing excess water from the slurry to form a porcelain clay, and making the porcelain clay pass through a mold to form a fin-shaped green ware; and
performing a sintering manufacturing process to the green ware to form a ceramic heat sink module.

12. The manufacturing method as claimed in claim 11, wherein after the step of removing excess water from the slurry to form the porcelain clay and making the porcelain clay pass through the mold to form the fin-shaped green ware, the manufacturing method further comprises:
cutting the green ware; and
naturally drying the green ware.

13. The manufacturing method as claimed in claim 12, wherein after the step of performing the sintering manufacturing process to the green ware to form the ceramic heat sink module, the manufacturing method further comprises: polishing a bottom part of the ceramic heat sink module.

14. The manufacturing method as claimed in claim 11, 12 or 13, wherein the step of mixing the aluminium oxide powder to form the slurry further comprises: mixing the aluminium oxide and silicon dioxide powder to form the slurry.

15. The manufacturing method as claimed in claim 11, 12 or 13, wherein a composition of the ceramic heat sink module substantially includes 80% to 100% by weight aluminium oxide and 10% to 20% by weight silicon dioxide.
